# EUROPEAN PATENT APPLICATION

(11) **EP 4 167 028 A1**
(43) Date of publication of application: **19.04.2023**
(21) Application number: 21822975.5
(22) Date of filing: 14.05.2021
(51) Int. Cl.: G03F 7/004, G03F 7/038, G03F 7/20, G03F 7/38

(54) **NEGATIVE RESIST FILM LAMINATE AND PATTERN FORMATION METHOD**

(30) Priority: 10.06.2020 JP 2020100786
(71) Applicant: SHIN-ETSU CHEMICAL CO., LTD., Tokyo 1000005 (JP)
(72) Inventor: HIRANO, Yoshinori, Annaka-shi, Gunma 379-0224 (JP); ASAI, Satoshi, Annaka-shi, Gunma 379-0224 (JP)
(74) Representative: Ter Meer Steinmeister & Partner
(86) International application number: PCT/JP2021/018421
(87) International publication number: WO 2021/251063

(57) **Abstract**

Provided is a negative resist film laminate comprising a thermoplastic film, which is a first support body, and a negative resist film, wherein the negative resist film contains (A) an alkali-soluble resin having a phenolic hydroxy group, (B) a plasticizer containing polyester, (C) a photoacid generator, (D) an epoxy compound containing on average four or more epoxy groups per molecule, and (E) a benzotriazole compound and/or an imidazole compound.

## Description

### TECHNICAL FIELD

This invention relates to a negative resist film laminate and a pattern forming method.

### BACKGROUND ART

The process for manufacturing semiconductor devices generally involves the step of applying a resist material to a support such as a film, sheet, metal substrate or ceramic substrate to form a resist film thereon. Since the surface of the support is stepped as a result of circuit formation, the resist material used in the later stage of the semiconductor device manufacturing process must meet uniform coating on the stepped surface and eliminate the generation of defects such as voids. When a liquid resist material is applied to the surface of such a nonuniform stepped support, it is difficult to form a coating of uniform thickness with the likelihood of generating voids near steps. The liquid resist material is thus difficult to meet the above-mentioned requirements whereas a resist film is rather adequate.

With respect to the negative resist film meeting such requirements, Patent Document 1 describes a film material comprising an organosiloxane base resin and having flexibility. Since its development relies on organic solvent development which is different from the alkaline aqueous solution development, there arises a problem that the equipment for development must be altered. Also, Patent Document 2 describes a negative resist film capable of mitigating the generation of voids on stepped substrates. Since the film as cured has poor chemical resistance, it is desired to overcome this problem.

### PRIOR ART DOCUMENTS

### PATENT DOCUMENTS

Patent Document 1: JP-A 2011-145664
Patent Document 2: JP-A 2019-128438

### SUMMARY OF INVENTION

### TECHNICAL PROBLEM

An object of the invention, which has been made under the above-mentioned circumstances, is to provide a negative resist film laminate which is capable of transferring a negative resist film to a stepped support without generating voids, the resist film having excellent chemical resistance after curing, and a pattern forming method.

### SOLUTION TO PROBLEM

Making extensive investigations to attain the above object, the inventors have found that the outstanding problem is solved by a negative resist film laminate comprising a thermoplastic film and a negative resist film comprising an alkali-soluble resin having a phenolic hydroxy group, a polyester-containing plasticizer, a photoacid generator, an epoxy compound containing on average at least 4 epoxy groups per molecule, and a benzotriazole compound and/or imidazole compound. The invention is predicated on this finding.

The invention provides a negative resist film laminate and a pattern forming method as defined below.
1. A negative resist film laminate comprising a thermoplastic film as a first support and a negative resist film, the negative resist film comprising
   (A) an alkali-soluble resin having a phenolic hydroxy group,
   (B) a plasticizer containing a polyester,
   (C) a photoacid generator,
   (D) an epoxy compound containing on average at least 4 epoxy groups per molecule, and
   (E) a benzotriazole compound and/or imidazole compound.
2. The laminate of 1 wherein the polyester is a polyfunctional carboxylic acid polyester having 2 to 6 carboxy groups.
3. A method for forming a pattern, comprising the steps of:
   (1) transferring the negative resist film of the laminate of 1 or 2 to a second support,
   (2) exposing the resist film to radiation, and
   (3) developing the resist film in an alkaline aqueous solution.
4. The pattern forming method of 3 wherein step (1) includes heat treatment after the transfer.
5. The pattern forming method of 3 or 4 wherein step (2) includes heat treatment after the exposure.

### ADVANTAGEOUS EFFECTS OF INVENTION

The negative resist film laminate of the invention is capable of transferring a negative resist film even onto a stepped support without generating voids and eventually forming a pattern having high chemical resistance after curing.

### DESCRIPTION OF EMBODIMENTS

### [Negative resist film laminate]

The invention provides a negative resist film laminate comprising a thermoplastic film as a first support and a negative resist film which can be transferred to a second support.

### [Thermoplastic film]

The thermoplastic film as a first support is to become a release substrate and is not particularly limited as long as it can be peeled from the negative resist film without damaging the shape thereof. The thermoplastic film may be either a monolayer film in the form of a single polymer film or a multilayer film consisting of a plurality of polymer films. Exemplary are plastic films including nylon film, polyethylene (PE) film, polyethylene terephthalate (PET) film, polyethylene naphthalate film, polyphenylene sulfide (PPS) film, polypropylene (PP) film, polystyrene film, polymethylpentene (TPX) film, polycarbonate film, fluorinated film, special polyvinyl alcohol (PVA) film, and release-treated polyester film.

Of these, the PET film and PP film having adequate flexibility, mechanical strength and heat resistance are preferred as the first support. These films may have been subjected to various treatments such as corona treatment and release agent coating. Any commercial products may be used as the thermoplastic film, for example, Cerapeel^{®} WZ(RX) and BX8(R) (Toray Advanced Film Co., Ltd.), E7302 and E7304 (Toyobo Co., Ltd.), Purex^{®} G31 and G71T1 (Teijin Film Solutions Co., Ltd.), PET38x1-A3, PET38x1-V8 and PET38x1-X08 (Nippa Co., Ltd.). As used herein, the term "flexibility" means that a film is so flexible or soft at normal temperature and pressure that it does not crack when deformed.

### [Negative resist film]

The negative resist film contains (A) an alkali-soluble resin having a phenolic hydroxy group, (B) a polyester-containing plasticizer, (C) a photoacid generator, (D) an epoxy compound containing on average at least 4 epoxy groups per molecule, and (E) a benzotriazole compound and/or imidazole compound.

### [(A) Alkali-soluble resin having phenolic hydroxy group]

An alkali-soluble resin having a phenolic hydroxy group is used as the base resin of the negative resist film. Examples thereof include novolak resins obtained from polycondensation of phenols with aldehydes in the presence of acid catalysts, polyhydroxystyrene resins, and resins obtained from copolymerization of hydroxystyrene with another radical-polymerizable monomer (e.g., acrylic monomers such as methyl acrylate and methyl methacrylate, and styrene). Inter alia, novolak resins are preferred.

Suitable phenols include phenol; xylenols such as m-cresol, o-cresol, p-cresol, 2,3-xylenol, 2,5-xylenol, 3,5-xylenol, and 3,4-xylenol; alkylphenols such as m-ethylphenol, p-ethylphenol, o-ethylphenol, 2,3,5-trimethylphenol, 2,3,5-triethylphenol, 4-tert-butylphenol, 3-tert-butylphenol, 2-tert-butylphenol, 2-tert-butyl-4-methylphenol, 2-tert-butyl-5-methylphenol, and 6-tert-butyl-3-methylphenol; alkoxyphenols such as p-methoxyphenol, m-methoxyphenol, p-ethoxyphenol, m-ethoxyphenol, p-propoxyphenol, and m-propoxyphenol; isopropenylphenols such as o-isopropenylphenol, p-isopropenylphenol, 2-methyl-4-isopropenylphenol, and 2-ethyl-4-isopropenylphenol; polyhydroxyphenols such as 4,4'-dihydroxybiphenyl, bisphenol A, phenylphenol, resorcinol, hydroquinone, and pyrogallol; hydroxynaphthalenes such as α-naphthol, β-naphthol, and dihydroxynaphthalene. Of these, phenol, o-cresol, m-cresol, p-cresol, 2,3-xylenol, 2,5-xylenol and/or 3,5-xylenol is preferred as the reactant, with m-cresol and/or p-cresol being more preferred.

Suitable aldehydes include formaldehyde, paraformaldehyde, trioxane, acetaldehyde, propionaldehyde, butylaldehyde, trimethylactaldehyde, acrolein, crotonaldehyde, cyclohexanealdehyde, furfural, furylacrolein, benzaldehyde, terephthalaldehyde, phenylactaldehyde, α-phenylpropylaldehyde, β-phenylpropylaldehyde, o-hydroxybenzaldehyde, m-hydroxybenzaldehyde, p-hydroxybenzaldehyde, o-methylbenzaldehyde, m-methylbenzaldehyde, p-methylbenzaldehyde, o-chlorobenzaldehyde, m-chlorobenzaldehyde, and p-chlorobenzaldehyde. They may be used alone or in admixture of two or more. Of these aldehydes, formaldehyde is preferred for availability.

The novolak resin is obtained using phenols as one reactant, preferably p-cresol in an amount of at least 40 mol%, more preferably at least 45 mol% of the phenols. The upper limit of the amount of p-cresol is 100 mol% of the phenols. When another phenol is used in addition to p-cresol, the upper limit of the amount of p-cresol is preferably 80 mol%, more preferably 70 mol% of the phenols. The other phenol is preferably selected from m-cresol, 2,5-xylenol, and 3,5-xylenol, with m-cresol being most preferred.

The resin as component (A) preferably has a weight average molecular weight (Mw) of 3,000 to 50,000, more preferably 5,000 to 30,000. As used herein, Mw is as measured by gel permeation chromatography (GPC) versus polystyrene standards using tetrahydrofuran (THF) solvent.

The resin as component (A) may be used alone or in admixture of two or more.

### [(B) Plasticizer]

Component (B) is a plasticizer containing a polyester. The polyester is a condensate of a polyfunctional carboxylic acid with a polyhydric alcohol or a condensate of a polyfunctional carboxylic acid anhydride with a polyhydric alcohol.

The polyfunctional carboxylic acid is preferably selected those acids having 2 to 6 carboxy groups, for example, oxalic acid, succinic acid, malonic acid, glutaric acid, adipic acid, pimelic acid, suberic acid, azelaic acid, sebacic acid, brassylic acid, methylmalonic acid, citraconic acid, fumaric acid, maleic acid, methylmaleic acid, mesaconic acid, glutaconic acid, itaconic acid, allylmalonic acid, teraconic acid, muconic acid, 2-butynedioic acid, aconitic acid, malic acid, tartaric acid, dl-tartaric acid, citric acid, oxomalonic acid, oxosuccinic acid, thiomalic acid, glutamic acid, ethylene diamine tetraacetic acid, 1,2-cyclopropane dicarboxylic acid, truxillic acid, camphoric acid, phthalic acid, isophthalic acid, terephthalic acid, phenylsuccinic acid, 2-(3-carboxyphenyl)-2-oxoacetic acid, meconic acid, and cyclobutane dicarboxylic acid. Anhydrides of the foregoing acids are also useful. Of these, difunctional carboxylic acids are preferred. The polyfunctional carboxylic acids may be used alone or in admixture of two or more.

Suitable polyhydric alcohols include 1,2-propanediol, 1,3-propanediol, 1,2-butanediol, 1,3-butanediol, 3-methyl-1,3-butanediol, 1,4-butanediol, 1,4-cyclohexanemethanediol, 1,2-pentanediol, 1,3-pentanediol, 1,5-pentanediol, 1,6-hexanediol, 2-methyl-2,4-pentanediol, 3-methyl-1,5-pentanediol, ethylene glycol, propylene glycol, neopentyl glycol, glycerin, and pentaglycerol. Of these, dihydric alcohols are preferred. The polyhydric alcohols may be used alone or in admixture of two or more.

Polyesters are obtained by using the above-mentioned reactants and carrying out polycondensation according to the well-known method. The amounts of the reactants used may be adjusted as appropriate depending on the desired molecular weight of the resulting polymer. Typically, about 0.5 to 3 moles of the polyhydric alcohol is used per mole of the polyfunctional carboxylic acid. For esterification, any well-known methods may be used. Typically, condensation reaction is carried out by using an acidic catalyst such as sulfuric acid or a metal compound such as a titanium compound, tin compound, zinc compound, germanium compound or antimony compound and optionally heating at about 150 to 300°C.

Any commercial products may be used as the polyester, for example, Polysizer^{®} W-2050, W-2310, W-230-H, W-1020-EL, W-1410-EL, and W-705 (DIC Corp.), ADK Cizer^{®} PN-150, PN-170, PN-230, PN-280, PN-7230, PN-1010, PN-1020, PN-1030, P-200, PN-260, PN-650, PN-7650, PN-1430, HPN-3130, PN-446, and PN-7310 (ADEKA Corp.); D620, D621, D623, D643, D64, D633, D620N, D623N, D643D, and D640A (J-Plus Co., Ltd.).

The polyester preferably has a Mw of 700 to 50,000, more preferably 1,500 to 45,000. This range of Mw is preferred because of a satisfactory development rate.

Since component (B) is one component of the negative resist film, it is preferably alkali-soluble, more preferably soluble in an aqueous solution of tetramethylammonium hydroxide (TMAH).

The plasticizer as component (B) may contain only the polyester while it may contain the polyester and another plasticizer. The other plasticizer may be selected from prior art well-known ones. The amount of the other plasticizer used is not particularly limited as long as the benefits of the invention are not impaired.

The amount of component (B) used is preferably 5 to 100 parts by weight, more preferably 10 to 60 parts by weight, even more preferably 15 to 50 parts by weight per 100 parts by weight of the resin as component (A). The amount in the range eliminates the risk that voids are generated when the negative resist film is transferred onto the second support. The polyester as component (B) may be used alone or in admixture of two or more.

### [(C) Photoacid generator]

The photoacid generator as component (C) is not particularly limited as long as it generates an acid upon exposure to high-energy radiation. Examples of the high-energy radiation include ultraviolet (UV), deep UV, and electron beam (EB), typically g-line, h-line, i-line, KrF excimer laser, ArF excimer laser, EB, and synchrotron radiation.

Suitable PAGs include sulfonium salts, iodonium salts, sulfonyldiazomethanes, N-sulfonyloxyimide PAGs, benzoin sulfonate PAGs, pyrogallol trisulfonate PAGs, nitrobenzylsulfonate PAGs, sulfone PAGs, O-arylsulfonyloxime or O-alkylsulfonyloxime compound (i.e., oxime sulfonate) PAGs.

Sulfonium salts are salts of sulfonium cations with sulfonate anions. Exemplary sulfonium cations include triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-di-tert-butoxyphenyl)diphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl(2-naphthyl)sulfonium, 4-hydroxyphenyldimethylsulfonium, 4-methoxyphenyldimethylsulfonium, trimethylsulfonium, 2-oxocyclohexylcyclohexylmethylsulfonium, trinaphthylsulfonium, and tribenzylsulfonium. Exemplary sulfonate anions include trifluoromethanesulfonate, nonafluorobutanesulfonate, heptadecafluorooctanesulfonate, 2,2,2-trifluoroethanesulfonate, pentafluorobenzenesulfonate, 4-(trifluoromethyl)benzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Sulfonium salts based on combination of the foregoing examples are preferred.

Iodonium salts are salts of iodonium cations with sulfonate anions. Exemplary iodonium cations include aryl iodonium cations such as diphenyliodonium, bis(4-tert-butylphenyl)iodonium, 4-tert-butoxyphenylphenyliodonium, and 4-methoxyphenylphenyliodonium. Exemplary sulfonate anions include trifluoromethanesulfonate, nonafluorobutanesulfonate, heptadecafluorooctanesulfonate, 2,2,2-trifluoroethanesulfonate, pentafluorobenzenesulfonate, 4-(trifluoromethyl)benzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Iodonium salts based on combination of the foregoing examples are preferred.

Exemplary sulfonyldiazomethane compounds include bissulfonyldiazomethane compounds and sulfonylcarbonyldiazomethane compounds such as bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, and tert-butoxycarbonyl-4-methylphenylsulfonyldiazomethane.

Suitable N-sulfonyloxyimide PAGs include imide compounds whose nitrogen-bonded hydrogen is replaced by a sulfonyloxy group. Suitable imides include succinimide, naphthalene dicarboxylic acid imide, phthalimide, cyclohexyldicarboxylic acid imide, 5-norbornene-2,3-dicarboxylic acid imide, and 7-oxabicyclo[2.2.1]-5-heptene-2,3-dicarboxylic acid imide. Suitable sulfonyloxy groups include trifluoromethanesulfonyloxy, nonafluorobutanesulfonyloxy, heptadecafluorooctanesulfonyloxy, 2,2,2-trifluoroethanesulfonyloxy, pentafluorobenzenesulfonyloxy, 4-trifluoromethylbenzenesulfonyloxy, 4-fluorobenzenesulfonyloxy, toluenesulfonyloxy, benzenesulfonyloxy, naphthalenesulfonyloxy, camphorsulfonyloxy, octanesulfonyloxy, dodecylbenzenesulfonyloxy, butanesulfonyloxy, and methanesulfonyloxy.

Suitable benzoinsulfonate PAGs include benzoin tosylate, benzoin mesylate, and benzoin butanesulfonate.

Suitable pyrogallol trisulfonate PAGs include pyrogallol, phloroglucin, catechol, resorcinol, and hydroquinone compounds in which all hydroxy groups are substituted by sulfonyloxy groups such as trifluoromethanesulfonyloxy, nonafluorobutanesulfonyloxy, heptadecafluorooctanesulfonyloxy, 2,2,2-trifluoroethanesulfonyloxy, pentafluorobenzenesulfonyloxy, 4-trifluoromethylbenzenesulfonyloxy, 4-fluorobenzenesulfonyloxy, toluenesulfonyloxy, benzenesulfonyloxy, naphthalenesulfonyloxy, camphorsulfonyloxy, octanesulfonyloxy, dodecylbenzenesulfonyloxy, butanesulfonyloxy, or methanesulfonyloxy.

Suitable nitrobenzyl sulfonate PAGs include esters of nitrobenzyl alcohols with sulfonic acids. Exemplary nitrobenzyl alcohols include 2,4-dinitrobenzyl sulfonate, 2-nitrobenzyl sulfonate, and 2,6-dinitrobenzyl sulfonate. Exemplary sulfonic acids include trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate. Analogous compounds in which the nitro group is substituted by trifluoromethyl may also be used as the PAG.

Suitable sulfone PAGs include bis(phenylsulfonyl)methane, bis(4-methylphenylsulfonyl)methane, bis(2-naphthylsulfonyl)methane, 2,2-bis(phenylsulfonyl)propane, 2,2-bis(4-methylphenylsulfonyl)propane, 2,2-bis(2-naphthylsulfonyl)propane, 2-methyl-2-(p-toluenesulfonyl)propiophenone, 2-cyclohexylcarbonyl-2-(p-toluenesulfonyl)propane, and 2,4-dimethyl-2-(p-toluenesulfonyl)pentan-3-one.

Suitable O-arylsulfonyloxime and O-alkylsulfonyloxime compound (i.e., oxime sulfonate) PAGs include PAGs in the form of glyoxime derivatives; PAGs in the form of oxime sulfonates with a long conjugated system separated by thiophene or cyclohexadiene; oxime sulfonates having an electron withdrawing group such as trifluoromethyl incorporated for increased stability; oxime sulfonates using substituted acetonitrile derivatives such as phenylacetonitrile; and bisoxime sulfonates.

Suitable PAGs in the form of glyoxime derivatives include bis-O-(p-toluenesulfonyl)-α-dimethylglyoxime, bis-O-(p-toluenesulfonyl)-α-diphenylglyoxime, bis-O-(p-toluenesulfonyl)-α-dicyclohexylglyoxime, bis-O-(p-toluenesulfonyl)-2,3-pentanedionedioxime, bis-O-(n-butanesulfonyl)-α-dimethylglyoxime, bis-O-(n-butanesulfonyl)-α-diphenylglyoxime, bis-O-(n-butanesulfonyl)-α-dicyclohexylglyoxime, bis-O-(methanesulfonyl)-α-dimethylglyoxime, bis-O-(trifluoromethanesulfonyl)-α-dimethylglyoxime, bis-O-(2,2,2-trifluoroethanesulfonyl)-α-dimethylglyoxime, bis-O-(10-camphorsulfonyl)-α-dimethylglyoxime, bis-O-(benzenesulfonyl)-α-dimethylglyoxime, bis-O-(4-fluorobenzenesulfonyl)-α-dimethylglyoxime, bis-O-(4-trifluoromethylbenzenesulfonyl)-α-dimethylglyoxime, bis-O-(xylenesulfonyl)-α-dimethylglyoxime, bis-O-(trifluoromethanesulfonyl)-nioxime, bis-O-(2,2,2-trifluoroethanesulfonyl)-nioxime, bis-O-(10-camphorsulfonyl)-nioxime, bis-O-(benzenesulfonyl)-nioxime, bis-O-(4-fluorobenzenesulfonyl)-nioxime, bis-O-(4-(trifluoromethyl)benzenesulfonyl)-nioxime, and bis-O-(xylenesulfonyl)-nioxime.

Suitable PAGs in the form of oxime sulfonates with a long conjugated system separated by thiophene or cyclohexadiene include (5-(p-toluenesulfonyl)oxyimino-5H-thiophen-2-ylidene)phenylacetonitrile, (5-(10-camphorsulfonyl)oxyimino-5H-thiophen-2-ylidene)phenylacetonitrile, (5-n-octanesulfonyloxyimino-5H-thiophen-2-ylidene)phenylacetonitrile, (5-(p-toluenesulfonyl)oxyimino-5H-thiophen-2-ylidene)(2-methylphenyl)acetonitrile, (5-(10-camphorsulfonyl)oxyimino-5H-thiophen-2-ylidene)(2-methylphenyl)acetonitrile, (5-n-octanesulfonyloxyimino-5H-thiophen-2-ylidene)(2-methylphenyl)acetonitrile, (5-(4-(p-toluenesulfonyloxy)benzenesulfonyl)oxyimino-5H-thiophen-2-ylidene)phenylacetonitrile, and (5-(2,5-bis(p-toluenesulfonyloxy)benzenesulfonyl)oxyimino-5H-thiophen-2-ylidene)-phenylacetonitrile.

Suitable PAGs in the form of oxime sulfonates having an electron withdrawing group such as trifluoromethyl incorporated for increased stability include 2,2,2-trifluoro-1-phenyl-ethanone O-(methylsulfonyl)oxime, 2,2,2-trifluoro-1-phenyl-ethanone O-(10-camphorsulfonyl)oxime, 2,2,2-trifluoro-1-phenylethanone O-(4-methoxybenzenesulfonyl)oxime, 2,2,2-trifluoro-1-phenylethanone O-(1-naphthylsulfonyl)oxime, 2,2,2-trifluoro-1-phenylethanone O-(2-naphthylsulfonyl)oxime, 2,2,2-trifluoro-1-phenylethanone O-(2,4,6-trimethylphenylsulfonyl)oxime, 2,2,2-trifluoro-1-(4-methylphenyl)ethanone O-(10-camphorsulfonyl)oxime, 2,2,2-trifluoro-1-(4-methylphenyl)ethanone O-(methylsulfonyl)oxime, 2,2,2-trifluoro-1-(2-methylphenyl)ethanone O-(10-camphorsulfonyl)oxime, 2,2,2-trifluoro-1-(2,4-dimethylphenyl)ethanone O-(10-camphorsulfonyl)oxime, 2,2,2-trifluoro-1-(2,4-dimethylphenyl)ethanone O-(1-naphthylsulfonyl)oxime, 2,2,2-trifluoro-1-(2,4-dimethylphenyl)-ethanone O-(2-naphthylsulfonyl)oxime, 2,2,2-trifluoro-1-(2,4,6-trimethylphenyl)ethanone O-(10-camphorsulfonyl)oxime, 2,2,2-trifluoro-1-(2,4,6-trimethylphenyl)ethanone O-(1-naphthylsulfonyl)oxime, 2,2,2-trifluoro-1-(2,4,6-trimethylphenyl)ethanone O-(2-naphthylsulfonyl)oxime, 2,2,2-trifluoro-1-(4-methoxyphenyl)ethanone O-(methylsulfonyl)oxime, 2,2,2-trifluoro-1-(4-methylthiophenyl)-ethanone O-(methylsulfonyl)oxime, 2,2,2-trifluoro-1-(3,4-dimethoxyphenyl)ethanone O-(methylsulfonyl)oxime, 2,2,2-trifluoro-1-(4-methoxyphenyl)ethanone O-(4-methylphenylsulfonyl)oxime, 2,2,2-trifluoro-1-(4-methoxyphenyl)ethanone O-(4-methoxyphenylsulfonyl)oxime, 2,2,2-trifluoro-1-(4-methoxyphenyl)ethanone O-(4-dodecylphenylsulfonyl)oxime, 2,2,2-trifluoro-1-(4-methoxyphenyl)ethanone O-(octylsulfonyl)oxime, 2,2,2-trifluoro-1-(4-thiomethylphenyl)ethanone O-(4-methoxyphenylsulfonyl)oxime, 2,2,2-trifluoro-1-(4-thiomethylphenyl)ethanone O-(4-dodecylphenylsulfonyl)oxime, 2,2,2-trifluoro-1-(4-thiomethylphenyl)ethanone O-(octylsulfonyl)oxime, 2,2,2-trifluoro-1-(4-thiomethylphenyl)ethanone O-(2-naphthylsulfonyl)oxime, 2,2,2-trifluoro-1-(2-methylphenyl)ethanone O-(methylsulfonyl)oxime, 2,2,2-trifluoro-1-(4-methylphenyl)ethanone O-(phenylsulfonyl)oxime, 2,2,2-trifluoro-1-(4-chlorophenyl)ethanone O-(phenylsulfonyl)oxime, 2,2,3,3,4,4,4-heptafluoro-1-phenylbutanone O-(10-camphorsulfonyl)oxime, 2,2,2-trifluoro-1-(1-naphthyl)ethanone O-(methylsulfonyl)oxime, 2,2,2-trifluoro-1-(2-naphthyl)ethanone O-(methylsulfonyl)oxime, 2,2,2-trifluoro-1-(4-benzylphenyl)ethanone O-(methylsulfonyl)oxime, 2,2,2-trifluoro-1-(4-(phenyl-1,4-dioxa-but-1-yl)phenyl)ethanone O-(methylsulfonyl)oxime, 2,2,2-trifluoro-1-(1-naphthyl)ethanone O-(propylsulfonyl)oxime, 2,2,2-trifluoro-1-(2-naphthyl)ethanone O-(propylsulfonyl)oxime, 2,2,2-trifluoro-1-(4-benzylphenyl)ethanone O-(propylsulfonyl)oxime, 2,2,2-trifluoro-1-(4-methylsulfonylphenyl)ethanone O-(propylsulfonyl)oxime, 2,2,2-trifluoro-1-(4-methylsulfonyloxyphenyl)ethanone O-(propylsulfonyl)oxime, 2,2,2-trifluoro-1-(4-methylcarbonyloxyphenyl)ethanone O-(propylsulfonyl)oxime, 2,2,2-trifluoro-1-(6H,7H-5,8-dioxonaphth-2-yl)ethanone O-(propylsulfonyl)oxime, 2,2,2-trifluoro-1-(4-methoxycarbonylmethoxyphenyl)ethanone O-(propylsulfonyl)oxime, 2,2,2-trifluoro-1-(4-methoxycarbonyl)-(4-amino-1-oxa-pent-1-yl)phenyl)ethanone O-(propylsulfonyl)oxime, 2,2,2-trifluoro-1-(3,5-dimethyl-4-ethoxyphenyl)ethanone O-(propylsulfonyl)oxime, 2,2,2-trifluoro-1-(4-benzyloxyphenyl)ethanone O-(propylsulfonyl)oxime, 2,2,2-trifluoro-1-(2-thiophenyl)ethanone O-(propylsulfonate)oxime, and 2,2,2-trifluoro-1-(1-dioxathiophen-2-yl)ethanone O-(propylsulfonate)oxime; 2,2,2-trifluoro-1-(4-(3-(4-(2,2,2-trifluoro-1-(trifluoromethanesulfonyloxyimino)ethyl)-phenoxy)propoxy)phenyl)ethanone O-(trifluoromethanesulfonyl)oxime, 2,2,2-trifluoro-1-(4-(3-(4-(2,2,2-trifluoro-1-(1-propanesulfonyloxyimino)ethyl)phenoxy)propoxy)phenyl)ethanone O-(propylsulfonyl)oxime, 2,2,2-trifluoro-1-(4-(3-(4-(2,2,2-trifluoro-1-(1-butanesulfonyloxyimino)ethyl)phenoxy)propoxy)phenyl)ethanone O-(butylsulfonyl)oxime, 2,2,2-trifluoro-1-(4-(3-(4-(2,2,2-trifluoro-1-(4-(4-methylphenylsulfonyloxy)phenyl-sulfonyloxyimino)ethyl)phenoxy)propoxy)phenyl)ethanone O-(4-(4-methylphenyl-sulfonyloxy)phenylsulfonyl)oxime, and 2,2,2-trifluoro-1-(4-(3-(4-(2,2,2-trifluoro-1-(2,5-bis(4-methylphenylsulfonyloxy)-benzenesulfonyloxy)phenylsulfonyloxyimino)ethyl)phenoxy)propoxy)phenyl)ethanone O-(2,5-bis(4-methylphenylsulfonyloxy)benzenesulfonyloxy)phenylsulfonyl)oxime.

Suitable oxime sulfonate PAGs using substituted acetonitrile derivatives include α-(p-toluenesulfonyloxyimino)-phenylacetonitrile, α-(p-chlorobenzenesulfonyloxyimino)-phenylacetonitrile, α-(4-nitrobenzenesulfonyloxyimino)-phenylacetonitrile, α-(4-nitro-2-trifluoromethylbenzenesulfonyloxyimino)-phenylacetonitrile, α-(benzenesulfonyloxyimino)-4-chlorophenylacetonitrile, α-(benzenesulfonyloxyimino)-2,4-dichlorophenylacetonitrile, α-(benzenesulfonyloxyimino)-2,6-dichlorophenylacetonitrile, α-(benzenesulfonyloxyimino)-4-methoxyphenylacetonitrile, α-(2-chlorobenzenesulfonyloxyimino)-4-methoxyphenylacetonitrile, α-(benzenesulfonyloxyimino)-2-thienylacetonitrile, α-(4-dodecylbenzenesulfonyloxyimino)-phenylacetonitrile, α-[(4-toluenesulfonyloxyimino)-4-methoxyphenyl]acetonitrile, α-[(dodecylbenzenesulfonyloxyimino)-4-methoxyphenyl]acetonitrile, α-(tosyloxyimino)-3-thienylacetonitrile, α-(methylsulfonyloxyimino)-1-cyclopentenylacetonitrile, α-(ethylsulfonyloxyimino)-1-cyclopentenylacetonitrile, α-(isopropylsulfonyloxyimino)-1-cyclopentenylacetonitrile, α-(n-butylsulfonyloxyimino)-1-cyclopentenylacetonitrile, α-(ethylsulfonyloxyimino)-1-cyclohexenylacetonitrile, α-(isopropylsulfonyloxyimino)-1-cyclohexenylacetonitrile, and α-(n-butylsulfonyloxyimino)-1-cyclohexenylacetonitrile.

Suitable bisoxime sulfonate PAGs include bis(α-(p-toluenesulfonyloxy)imino)-p-phenylenediacetonitrile, bis(α-(benzenesulfonyloxy)imino)-p-phenylenediacetonitrile, bis(α-(methanesulfonyloxy)imino)-p-phenylenediacetonitrile, bis(α-(butanesulfonyloxy)imino)-p-phenylenediacetonitrile, bis(α-(10-camphorsulfonyloxy)imino)-p-phenylenediacetonitrile, bis(α-(trifluoromethanesulfonyloxy)imino)-p-phenylenediacetonitrile, bis(α-(4-methoxybenzenesulfonyloxy)imino)-p-phenylenediacetonitrile, bis(α-(p-toluenesulfonyloxy)imino)-m-phenylenediacetonitrile, bis(α-(benzenesulfonyloxy)imino)-m-phenylenediacetonitrile, bis(α-(methanesulfonyloxy)imino)-m-phenylenediacetonitrile, bis(α-(butanesulfonyloxy)imino)-m-phenylenediacetonitrile, bis(α-(10-camphorsulfonyloxy)imino)-m-phenylenediacetonitrile, bis(α-(trifluoromethanesulfonyloxy)imino)-m-phenylenediacetonitrile, and bis(α-(4-methoxybenzenesulfonyloxy)imino)-m-phenylenediacetonitrile.

Oxime sulfonates having the formula (C1) are also useful PAGs.

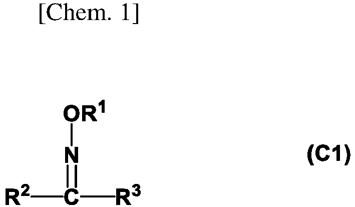

In formula (C1), R¹ is a substituted or unsubstituted C₁-C₁₀ haloalkylsulfonyl or halobenzenesulfonyl group, R² is a C₁-C₁₁ haloalkyl group, and R³ is a substituted or unsubstituted aryl or hetero-aryl group.

Examples of the oxime sulfonate having formula (C1) include 2-[2,2,3,3,4,4,5,5-octafluoro-1-(nonafluorobutylsulfonyloxyimino)-pentyl]fluorene, 2-[2,2,3,3,4,4-pentafluoro-1-(nonafluorobutylsulfonyloxyimino)butyl]fluorene, 2-[2,2,3,3,4,4,5,5,6,6-decafluoro-1-(nonafluorobutylsulfonyloxyimino)hexyl]fluorene, 2-[2,2,3,3,4,4,5,5-octafluoro-1-(nonafluorobutylsulfonyloxyimino)pentyl]-4-biphenyl, 2-[2,2,3,3,4,4-pentafluoro-1-(nonafluorobutylsulfonyloxyimino)butyl]-4-biphenyl, and 2-[2,2,3,3,4,4,5,5,6,6-decafluoro-1-(nonafluorobutylsulfonyloxyimino)hexyl]-4-biphenyl.

Among the foregoing compounds, the preferred PAGs are sulfonium salts, and bissulfonyldiazomethane, N-sulfonyloxyimide and sulfonyloxime compounds.

Although the optimum anion of the generated acid varies with such factors as ease of scission of the acid labile group in the polymer, an anion which is non-volatile and not extremely highly diffusive is generally selected. Appropriate anions include anions of benzenesulfonic acid, toluenesulfonic acid, 4-(4-toluenesulfonyloxy)benzenesulfonic acid, pentafluorobenzenesulfonic acid, 2,2,2-trifluoroethanesulfonic acid, nonafluorobutanesulfonic acid, heptadecafluorooctanesulfonic acid, and camphorsulfonic acid.

The amount of the PAG as component (C) is preferably 0.2 to 20 parts by weight, more preferably 0.3 to 10 parts by weight per 100 parts by weight of the resin as component (A). An amount in the range ensures a practically acceptable sensitivity and pattern profile. The PAG as component (C) may be used alone or in admixture of two or more. The transmittance of the resist film can be controlled by using a PAG having a low transmittance at the exposure wavelength and adjusting the amount of the PAG added.

### [(D) Epoxy compound containing on average at least 4 epoxy groups per molecule]

Component (D) is an epoxy compound containing on average at least 4 epoxy groups per molecule, which functions as a crosslinker. Examples of the epoxy compound include compounds having the formulae (D1) to (D3), but are not limited thereto.

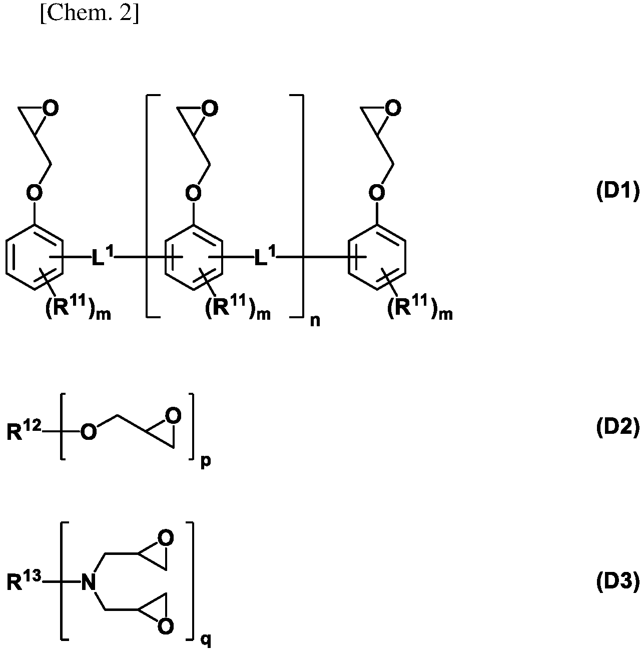

In formula (D1), m is an integer of 0 to 2, and n is an integer of at least 2, preferably 2 to 10.

In formula (D1), R¹¹ is a C₁-C₆ saturated hydrocarbyl group. The saturated hydrocarbyl group may be saturated or unsaturated and straight, branched or cyclic. Examples include C₁-C₃ alkyl groups such as methyl, ethyl, n-propyl, isopropyl, n-butyl, isobutyl, sec-butyl, tert-butyl, n-pentyl, and n-hexyl; and C₃-C₆ cyclic saturated hydrocarbyl groups such as cyclopropyl, cyclobutyl, cyclopentyl and cyclohexyl.

In formula (D1), L¹ is each independently a C₁-C₁₀ saturated hydrocarbylene group. The hydrocarbylene group may be straight, branched or cyclic. Examples thereof include alkanediyl groups such as methylene, ethylene, propane-1,2-diyl, propane-1,3-diyl, propane-2,2-diyl, butane-1,2-diyl, butane-1,3-diyl, butane-1,4-diyl; and cyclic saturated hydrocarbylene groups such as cyclopropanediyl, cyclopentane-1,2-diyl, and cyclohexane-1,2-diyl. Of these, methylene, ethylene, propane-1,2-diyl, propane-1,3-diyl, and propane-2,2-diyl are preferred.

In formulae (D2) and (D3), p is an integer of 4 to 8, and q is an integer of 2 to 4. R¹² is a C₆-C₃₀ p-valent hydrocarbon group which may contain at least one atom selected from nitrogen, oxygen and sulfur. R¹³ is a C₆-C₂₀ q-valent hydrocarbon group which may contain at least one atom selected from nitrogen, oxygen and sulfur.

Examples of the compound having formula (D2) are shown below, but not limited thereto.

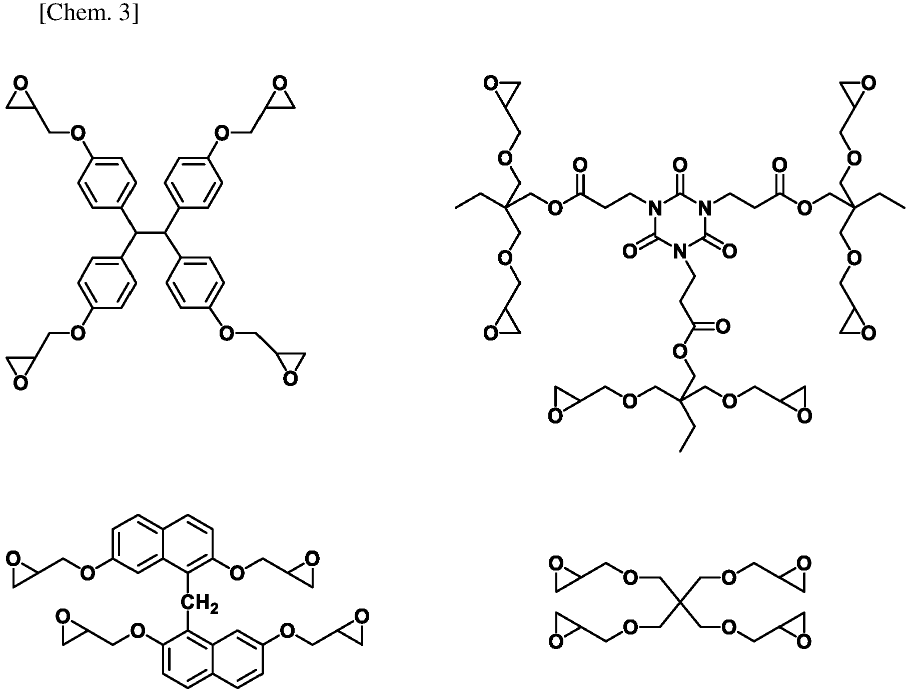

Examples of the compound having formula (D3) are shown below, but not limited thereto.

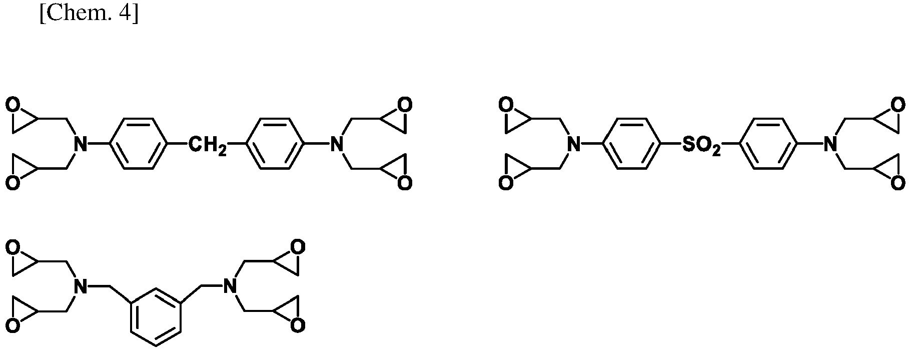

Of the compounds having formulae (D1) to (D3), those compounds having an aromatic ring are preferred.

The amount of component (D) is preferably 10 to 200 parts by weight, more preferably 30 to 100 parts by weight per 100 parts by weight of component (A). The epoxy compound as component (D) may be used alone or in admixture of two or more.

### [(E) Benzotriazole compound and imidazole compound]

The benzotriazole compound as component (E) is typically selected from compounds having the formulae (E1) and (E2).

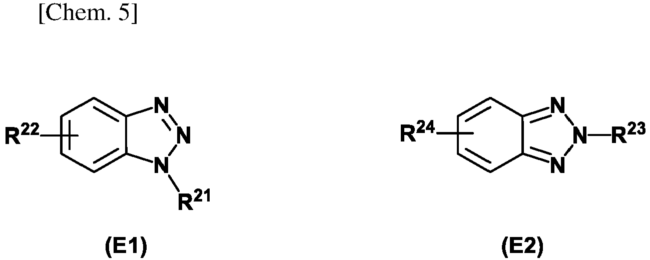

In formulae (E1) and (E2), R²¹ and R²³ are each independently hydrogen, hydroxy, amino, optionally substituted C₁-C₆ alkyl, optionally substituted phenyl, sulfonyl-containing substituent group, or -A¹-A². A¹ is carbonyl, C₁-C₁₂ saturated hydrocarbylene group or -A¹¹-O- wherein A¹¹ is a C₁-C₁₂ saturated hydrocarbylene group. A² is hydrogen, halogen, cyano, hydroxy, C₁-C₆ saturated hydrocarbyloxy, carboxy, or dihydrocarbylamino group in which each hydrocarbyl moiety is of 1 to 6 carbon atoms. The saturated hydrocarbylene group and the dihydrocarbyl moiety of the saturated hydrocarbyloxy group and dihydrocarbylamino group may be straight, branched or cyclic.

In formulae (E1) and (E2), R²² and R²⁴ are each independently hydrogen, halogen, hydroxy, optionally substituted C₁-C₆ saturated hydrocarbyl group, C₁-C₆ saturated hydrocarbyloxy group, sulfonyl-containing substituent group, or an organic group of the formula (E3): 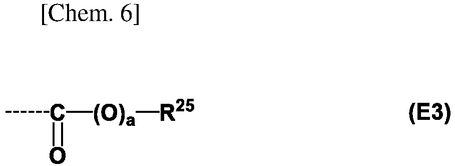 wherein R²⁵ is hydrogen or optionally substituted C₁-C₁₂ saturated hydrocarbyl group, "a" is 0 or 1, and the broken line designates a valence bond.

Examples of the benzotriazole compound include benzotriazole, 1-hydroxybenzotriazole, 1-methylbenzotriazole, 1-hydroxymethylbenzotriazole, 1-ethylbenzotriazole, 1-(1-hydroxyethyl)benzotriazole, 1-(2-hydroxyethyl)benzotriazole, 1-propylbenzotriazole, 1-(1-hydroxypropyl)benzotriazole, 1-(2-hydroxypropyl)benzotriazole, 1-(3-hydroxypropyl)benzotriazole, 4-hydroxy-1H-benzotriazole, 5-methyl-1H-benzotriazole, benzotriazole-5-carboxylic acid, 1-methylbenzotriazole-5-carboxylic acid, 1-ethylbenzotriazole-5-carboxylic acid, 1-t-butylbenzotriazole-5-carboxylic acid, 1-(2-cyclopentylethyl)benzotriazole-5-carboxylic acid, 1H-benzotriazole-4-sulfonic acid, 1H-benzotriazole-1-acetonitrile, 1H-benzotriazole-1-carboxy aldehyde, 2-methyl-2H-benzotriazole, and 2-ethyl-2H-benzotriazole.

The imidazole compound as component (E) is typically selected from compounds having the formulae (E4) to (E9).

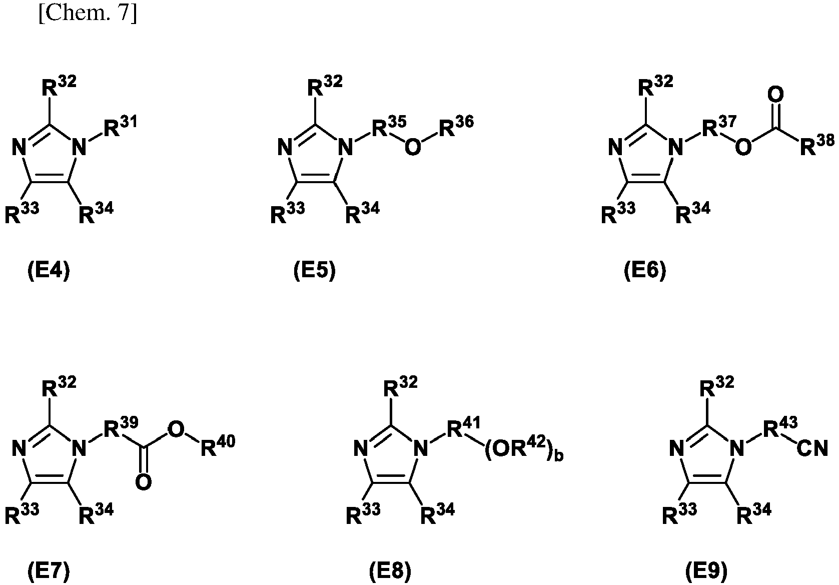

In formulae (E4) to (E9), R³¹ is hydrogen, or a C₂-C₂₀ saturated hydrocarbyl group having at least one polar functional moiety selected from among hydroxy, carbonyl, ester, ether, sulfide, carbonate, cyano and acetal. R³², R³³ and R³⁴ are each independently hydrogen, a C₁-C₁₀ saturated hydrocarbyl group, C₆-C₁₀ aryl or C₇-C₁₀ aralkyl group. R³⁵, R³⁷, R³⁹ and R⁴³ are each independently a C₁-C₁₀ saturated hydrocarbylene group. R³⁶ and R³⁸ are each independently hydrogen or a C₁-C₁₅ saturated hydrocarbyl group which may contain at least one moiety selected from among hydroxy, carbonyl, ester, ether, sulfide, carbonate, cyano and acetal. R⁴⁰ is a C₁-C₁₅ saturated hydrocarbyl group which may contain at least one moiety selected from among hydroxy, carbonyl, ester, ether, sulfide, carbonate, cyano and acetal. R⁴¹ is a (b+1)-valent C₂-C₁₀ hydrocarbon group. R⁴² is each independently hydrogen or a C₁-C₁₅ saturated hydrocarbyl group which may contain at least one moiety selected from among hydroxy, carbonyl, ester, ether, sulfide, carbonate, cyano and acetal, and two groups R⁴² may bond together to form a ring, and b is 2, 3, 4 or 5.

Preferred examples of the imidazole compound include imidazole, 2-methylimidazole, 1,2-dimethylimidazole, 2-ethyl-4-methylimidazole, 2-phenylimidazole, 2-phenyl-4-methylimidazole, 1-methoxymethylimidazole, N-tert-butoxycarbonylimidazole, 1-(2-cyanoethyl)-2-methylimidazole, 1-(2-hydroxyethyl)imidazole, 1-(carboxymethyl)imidazole, and 2-methyl- 1-vinylimidazole.

The amount of component (E) used is preferably 0.01 to 10 parts by weight, more preferably 0.02 to 5 parts by weight per 100 parts by weight of component (A). An amount of component (E) in the range ensures to form a pattern at a practically acceptable sensitivity. The compound as component (E) may be used alone or in admixture of two or more.

### [(F) Surfactant]

The negative resist film may further contain (F) a surfactant. Examples of the surfactant (F) include nonionic surfactants, for example, polyoxyethylene alkyl ethers such as polyoxyethylene lauryl ether, polyoxyethylene stearyl ether, polyoxyethylene cetyl ether, and polyoxyethylene oleyl ether, polyoxyethylene alkylaryl ethers such as polyoxyethylene octylphenyl ether and polyoxyethylene nonylphenyl ether, polyoxyethylene polyoxypropylene block copolymers, sorbitan fatty acid esters such as sorbitan monolaurate, sorbitan monopalmitate, and sorbitan monostearate, polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, and polyether silicone; fluorochemical surfactants such as EFTOP^{®} EF301, EF303 and EF352 (Tohkem Products Co., Ltd.), Megaface^{®} F171, F172 and F173 (DIC Corp.), Fluorad^{®} FC-4430, FC-430 and FC-431 (3M), Olfine^{®} E1004 (Nissin Chemical Industry Co., Ltd.), Asahiguard^{®} AG710 (AGC Inc.), Surflon^{®} S-381, S-382, SC101, SC102, SC103, SC104, SC105, SC106, KH-10, KH-20, KH-30 and KH-40 (AGC Seimi Chemical Co., Ltd.); organosiloxane polymers KP-341, X-70-092 and X-70-093 (Shin-Etsu Chemical Co., Ltd.), acrylic acid or methacrylic acid Polyflow No. 75 and No. 95 (Kyoeisha Ushi Kagaku Kogyo Co., Ltd.). Inter alia, Fluorad FC-4430 and X-70-093 are preferred. These surfactants may be used alone or in admixture.

The amount of the surfactant as component (F) is 0 to 5 parts, and when used, preferably 0.01 to 2 parts by weight per 100 parts by weight of the resin as component (A). The surfactant as component (F) may be used alone or in admixture.

### [Other components]

Other well-known additives may be added to the negative resist film insofar as the benefits of the invention are not impaired. Such additives include photobase generators, sensitizers, dissolution promoters such as water-soluble celluloses, stress relaxation agents such as polyvinyl alcohol and polyvinyl alkyl ether compounds, dyes such as azo compounds and curcumin, and shape improvers such as oxalic acid. The amount of such additives is arbitrary as long as the benefits of the invention are not impaired.

### [Method of preparing negative resist film laminate]

The method of preparing the negative resist film laminate is described. First, the above-mentioned components (A), (B), (C), (D) and (E) and optionally, (F) and other components are dissolved in an organic solvent at the same time or in any desired order to form a uniform negative resist solution. If necessary, the resulting uniform solution may be filtered through a filter.

The organic solvent used herein is not particularly limited as long as other components are soluble therein and satisfactory coating properties are achievable. Suitable organic solvents include cellosolve solvents such as methyl cellosolve, ethyl cellosolve, methyl cellosolve acetate, and ethyl cellosolve acetate; propylene glycol solvents such as propylene glycol and dipropylene glycol; propylene glycol alkyl ether solvents such as propylene glycol monomethyl ether (PGME) and propylene glycol monobutyl ether; propylene glycol alkyl ether acetate solvents such as propylene glycol monomethyl ether acetate (PGMEA), propylene glycol dimethyl ether, and propylene glycol monoethyl ether acetate; ester solvents such as butyl acetate, pentyl acetate, methyl lactate, ethyl lactate, methyl 3-methoxypropionate, and ethyl 3-ethoxypropionate; alcohol solvents such as methanol, ethanol, isopropanol, butanol, hexanol, and diacetone alcohol; ketone solvents such as acetone, cyclohexanone, cyclopentanone, methyl ethyl ketone, methyl pentyl ketone, and methyl isobutyl ketone; ether solvents such as methyl phenyl ether and diethylene glycol dimethyl ether; highly polar solvents such as N,N-dimethylformamide, N-methylpyrrolidone and dimethyl sulfoxide; and mixtures thereof.

Of these solvents, propylene glycol alkyl ether acetates, alkyl lactates, and alkyl ketones are preferred. It is noted that the alkyl group of the propylene glycol alkyl ether acetate is preferably of 1 to 4 carbon atoms, for example, methyl, ethyl and propyl, with methyl and ethyl being especially preferred. Since the propylene glycol alkyl ether acetates include 1,2- and 1,3-substituted ones, each includes three isomers depending on the combination of substituted positions, which may be used alone or in admixture. Also, the alkyl group of the alkyl lactate is preferably of 1 to 4 carbon atoms, for example, methyl, ethyl and propyl, with methyl and ethyl being especially preferred. The alkyl group of the alkyl ketone is preferably of 1 to 10 carbon atoms, for example, methyl, ethyl, propyl, isobutyl, cyclopentyl and cyclohexyl, with isobutyl, cyclopentyl and cyclohexyl being especially preferred.

The amount of the organic solvent used in the preparation of the negative resist solution is preferably 20 to 1,000 parts by weight, more preferably 30 to 200 parts by weight per 100 parts by weight of the resin as component (A). An amount of the organic solvent in the range ensures to form a film with a uniform thickness and avoids the risk of defects in the film. When the desired negative resist film laminate is prepared according to the invention by once dissolving the components uniformly in an excess of the organic solvent and drying (drying step is described later), the amount of the organic solvent used in the step of dissolving the components may be adjusted as appropriate depending on the thickness of the film to be formed.

The negative resist solution is coated on a thermoplastic film (release substrate) as the first support in a clean room having a cleanness of up to 1,000 by a film coater installed in a zone which is kept at a temperature of 5 to 45°C, preferably 15 to 35°C and a humidity of 5 to 90%, preferably 10 to 70%. Examples of the film coater include a forward roll coater, reverse roll coater, comma coater, die coater, lip coater, gravure coater, dip coater, air knife coater, capillary coater, raising and rising (R&R) coater, blade coater, bar coater, applicator, and extrusion molding machine. The coating speed is preferably 0.05 to 1,000 m/min, more preferably 0.1 to 500 m/min. Thereafter, the thermoplastic film coated with the negative resist solution is passed through an in-line dryer or hot air circulating oven preferably at 40 to 130°C for 1 to 40 minutes, more preferably at 50 to 120°C for 2 to 30 minutes, until the organic solvent and any volatiles are removed. By drying in this way, a negative resist film laminate is formed. A negative resist film laminate may also be constructed through solvent removal by infrared irradiation instead of the in-line dryer, or a combination of plural drying means such as simultaneous use of in-line dryer and infrared irradiation. If necessary, a protective film (or release substrate) may be press bonded to the negative resist film laminate by means of a roll laminator, yielding a laminate.

In one embodiment wherein a production line is constructed by using a molding machine and specific molding conditions such that the negative resist solution may be applied onto the thermoplastic film, a length of negative resist film laminate can be continuously formed and wound up in film roll form of desired shape which is convenient to handle. This is also true when the negative resist film laminate is overlaid with the protective film.

For example, when the support film is unwound from an unwind mandrel of the film coater and passed across the film coater head, the negative resist solution is coated onto the support film to a predetermined thickness. The coated support film is passed through a hot air circulating oven at a predetermined temperature over a predetermined time where the resist solution is dried on the support film. The support film and a protective film which is unwound from another unwind mandrel of the film coater are passed between laminator rolls under a predetermined pressure to bond the protective film to the negative resist layer on the support film. The assembly is taken up on a take-up mandrel of the film coater. In this way, the negative resist film laminate is prepared in roll form.

Like the thermoplastic film, the protective film is not particularly limited as long as the film does not adversely affect the shape of the negative resist film and can be peeled from the negative resist film. The film may be a single polymer film or a multilayer film consisting of a plurality of polymer layers. Suitable plastic films include nylon film, polyethylene (PE) film, polyethylene terephthalate (PET) film, polyethylene naphthalate film, polyphenylene sulfide (PPS) film, polypropylene (PP) film, polystyrene film, polymethylpentene (TPX) film, polycarbonate film, fluoro-resin film, special polyvinyl alcohol (PVA) film, and polyester film which has been treated with a parting agent.

Of these, films of PET and PE are preferred as the protective film because of appropriate flexibility. Commercially available films may be used as well. Useful PET films include Cerapeel^{®} WZ(RX) and BX8(R) (Toray Advanced Film Co., Ltd.), E7302 and E7304 (Toyobo Co., Ltd.), PET38x1-A3, PET38x1-V8 and PET38x1-X08 (Nippa Co., Ltd.). Useful PE films include GF-8 (Tamapoly Co., Ltd.), PE FILM 0 TYPE (Nippa Co., Ltd.), Toretec^{®} 7332, 7111 and 7721 (Toray Advanced Film Co., Ltd.).

The thermoplastic film and the protective film each have a thickness of preferably 10 to 150 µm, more preferably 25 to 100 µm, from the viewpoints of consistent film formation and anti-curling from the roll state wound around the take-up mandrel.

The negative resist film laminate of roll form prepared as above can be used over a long period of time because of storage stability.

The negative resist film is formed on the thermoplastic film such that it may be transferred to the second support. The negative resist film preferably has a thickness of 5 to 250 µm, more preferably 10 to 180 µm. As the second support, use may be made of plastic films or sheets, semiconductor substrates such as Si, Cu, SiO₂, SiN, SiON, TiN, WSi, BPSG, and SOG, metal substrates such as Au, Ti, W, Cu, Ni-Fe, Ta, Zn, Co and Pb, and other substrates such as organic antireflective coatings, and organic substrates. The second support may have steps (raised and recessed portions) on its surface, which are typically left after formation of a circuit or dielectric resin layer by plating, sputtering or the like. The steps are preferably of the order of 0 to 200 µm, more preferably 3 to 100 µm, even more preferably 10 to 50 µm.

The peeling force required to peel the protective film from the negative resist film prepared as above is typically in a range of 0.1 to 500 gf/24 mm, as measured by the method described below. The test method is in accord with JIS Z0237 "Bond strength testing method in peeling release liner from pressure-sensitive adhesive tape surface". The testing environment is under standard conditions (temperature 23±1°C, relative humidity 50±5%). A film sample to be tested has a width of 24 mm. A variation of film width is undesirable because the peeling force is accordingly changed. After a film sample of the predetermined size is prepared, the protective film is peeled by pulling it back at an angle of 180° and a rate of 5.0±0.2 mm/sec. Among measurements, initial measurements over starting distance 25 mm are taken off, and measurements over subsequent distance 50 mm are averaged and reported as the test value.

### [Pattern forming process]

The resist film of the negative resist film laminate may be bonded to the second support, typically semiconductor substrate using a suitable laminator such as vacuum laminator or roll laminator. Once the thermoplastic film is peeled off, the negative resist film is transferred to the second support. The second support may be of a stepped structure. In this case, the negative resist film having an appropriate thickness corresponding to the height of steps is used so that the resist film may be buried in steps. The resist film is advantageously applicable to a substrate having steps of the order of 0 to 200 µm. The transfer step may or may not be followed by heat treatment. Heat treatment is preferred from the aspect of enhancing the bond to the substrate. When heat treatment is performed, the assembly may be prebaked on a hotplate or in an oven at 60 to 150°C for 1 to 30 minutes, preferably at 80 to 130°C for 1 to 10 minutes.

Next, the resist film is exposed to radiation through a mask having a desired pattern, the radiation being selected from UV, deep UV and EB, preferably radiation with a wavelength of at least 300 nm, more preferably 350 to 500 nm. The exposure dose is preferably in the range of about 10 to 5,000 mJ/cm², more preferably about 30 to 2,000 mJ/cm². If desired from the aspect of enhancing sensitivity, the film may be baked (PEB) on a hotplate at 60 to 150°C for 1 to 10 minutes, preferably at 80 to 120°C for 1 to 5 minutes.

Thereafter the resist film is developed in a developer in the form of an aqueous alkaline solution, for example, 0.1 to 5 wt%, preferably 2 to 3 wt% aqueous solution of tetramethylammonium hydroxide (TMAH) for 0.1 to 60 minutes, preferably 0.5 to 10 minutes by a conventional technique such as dip, puddle or spray development. In this way, a desired resist pattern is formed on the second support. After the pattern formation, the surface may be rinsed if necessary.

After the development step, electroplating or electroless plating may be carried out to form a metal plating layer. That is, a metal plating pattern is obtained. Suitable electroplating or electroless plating methods include electrolytic Cu plating, electroless Cu plating, electrolytic Ni plating, electroless Ni plating, and electrolytic Au plating. Plating may be performed in any well-known plating baths and under standard conditions. The thickness of a plating layer is typically 80 to 100% of the thickness of the resist pattern. For example, a resist pattern of 1 µm thick is formed on a seed layer of Cu, after which a Cu plating pattern of 0.8 to 1 µm thick is deposited thereon by electrolytic Cu plating.

### EXAMPLES

Synthesis Examples, Examples, and Comparative Examples are given below for illustrating the invention although the invention is not limited thereto.

### [1] Synthesis of novolak resin

### [Synthesis Example 1]

A three-necked flask equipped with a stirrer, condenser and thermometer was charged with 54.1 g (0.5 mol) of p-cresol, 43.3 g (0.4 mol) of m-cresol, 12.2 g (0.1 mol) of 2,5-dimethylphenol, 52.3 g (0.549 mol) of 37 wt% aqueous solution of formaldehyde, and 0.30 g (2.40×10⁻³ mol) of oxalic acid dihydrate as polycondensation catalyst. The flask was dipped in an oil bath where the flask interior was kept at a temperature of 100°C to conduct polycondensation for 80 minutes. At the end of reaction, 500 mL of methyl isobutyl ketone (MIBK) was added to the reaction solution, which was stirred for 30 minutes. The water layer was separated off. The MIBK layer having the product extracted therein was washed 5 times with 300 mL of deionized water, followed by separation and vacuum stripping on an evaporator at 150°C and 4 mmHg. There was obtained 87 g of a novolak resin having a weight average molecular weight (Mw) of 6,000. The Mw was measured on a GPC column (two G-2000H6, one G-3000H6, and one G-4000H6, Tosoh Corp.) at a flow rate of 1.5 mL/min, elute THF, and column temperature 40°C.

### [2] Preparation of negative resist film laminate

### [Examples 1 to 8 and Comparative Examples 1 to 4]

Each of resist solutions 1 to 12 was prepared by mixing components (A) to (F) and other components in accordance with the formulation shown in Table 1 and passing the mixture through a membrane filter with a pore size of 1.0 µm.

The components in Table 1 are identified below.

### (A) Alkali-soluble resin having phenolic hydroxy group

| | |
|---|---|
| • NP1: | novolak resin synthesized in Synthesis Example 1 |
| • EP6050G: | novolak resin (Mw=2,500-4,000) by Asahi Organic Chemicals Industry Co., Ltd. |

### (B) Polyester

| | |
|---|---|
| • PE1: | Polysizer W-2050 (adipic acid base polyester, Mw=3,900, DIC Corp.) |
| • PE2: | ADK Cizer P-300 (adipic acid base polyester, Mw=4,900, ADEKA Corp.) |

### (C) Photoacid generator

| | |
|---|---|
| • PAG1: | PAI-101 (Midori Kagaku Co., Ltd.) |
| • PAG2: | HT-1CS (San-Apro Ltd.) |

### (D) Crosslinker

| | |
|---|---|
| • CL1: | EOCN-1020 (epoxy equivalent 191-207, Nippon Kayaku Co., Ltd.) |

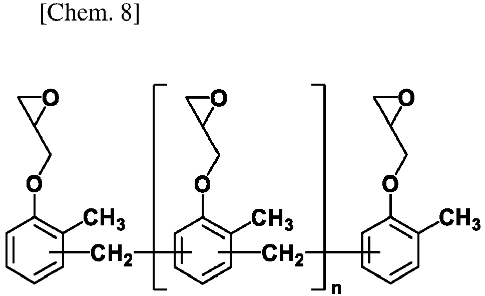

| | |
|---|---|
| • CL2: | TEPIC-UC (epoxy equivalent 185-205, Nissan Chemical Corp.) |

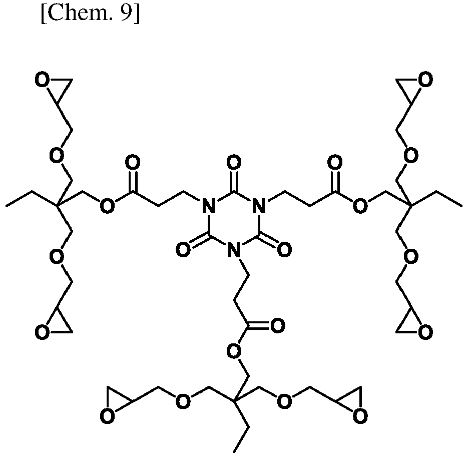

| | |
|---|---|
| • CL3: | TEP-G (epoxy equivalent 160-180, Asahi Organic Chemicals Industry Co., Ltd.) |

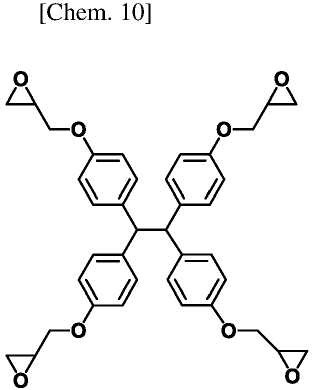

| | |
|---|---|
| • CL4: | Nikalak MW-30HM (methylated melamine, Sanwa Chemical Co., Ltd.) |

### (E) Benzotriazole/imidazole compound

| | |
|---|---|
| • BTA-1: | benzotriazole |
| • 4MI: | 4-methylimidazole |

### (F) Organic solvent

| | |
|---|---|
| • CP: | cyclopentanone |
| • PGMEA: | propylene glycol monomethyl ether acetate |

### (Other components)

| | |
|---|---|
| • KP-341: | Shin-Etsu Chemical Co., Ltd |
| • NT-300P: | Toyo Gosei Co., Ltd. |
| • Curcumin: | Sanwa Chemical Co., Ltd. |
| • Tris P-PA: | Honshu Chemical Co., Ltd. |

**[Table 1]**

| | Resist solution | Component (A) (pbw) | Component (B) (pbw) | Component (C) (pbw) | Component (D) (pbw) | Component (E) (pbw) | Organic solvent (pbw) | Other component (pbw) |
|---|---|---|---|---|---|---|---|---|
| Example 1 | 1 | NP1 (100) | PE1 (30) | PAG1 (2.0) | CL1 (30) | BTA (0.05) | PGMEA (100) | KP-341 (0.5) |
| Example 2 | 2 | NP1 (100) | PE1 (60) | PAG1 (1.5) | CL2 (10) | 4MI (0.05) | PGMEA (50) CP (50) | - |
| Example 3 | 3 | NP1 (100) | PE2 (20) | PAG2 (1.5) | CL3 (10) | BTA (0.03) | PGMEA (75) CP (25) | NT-300P (2.0) |
| Example 4 | 4 | NP1 (100) | PE2 (50) | PAG2 (1.0) | CL2 (20) | BTA (0.07) | PGMEA (60) CP (40) | - |
| Example 5 | 5 | EP6050G (100) | PE1 (25) | PAG2 (2.0) | CL3 (10) | 4MI (0.06) | CP (100) | KP-341 (0.3) |
| Example 6 | 6 | EP6050G (100) | PE1 (40) | PAG2 (1.0) | CL1 (30) | 4MI (0.10) | CP (60) PGMEA (40) | Curcumin (5.0) |
| Example 7 | 7 | EP6050G (100) | PE2 (10) | PAG1 (1.5) | CL1 (10) | BTA (0.02) | CP (10) PGMEA (90) | - |
| Example 8 | 8 | EP6050G (100) | PE2 (20) | PAG1 (2.5) | CL2 (30) | 4MI (0.05) | CP (75) PGMEA (25) | TrisP-PA (10) |
| Comparative Example 1 | 9 | NP1 (100) | PE1 (20) | PAG1 (1.0) | CL4 (20) | BTA (0.05) | PGMEA (100) | KP-341 (0.5) |
| Comparative Example 2 | 10 | NP1 (100) | - | PAG1 (2.0) | - | - | CP (100) | KP-341 (0.2) |
| Comparative Example 3 | 11 | EP6050G (100) | - | PAG2 (1.5) | CL4 (10) | BTA (0.07) | PGMEA (50) CP (50) | NT-300P (1.0) |
| Comparative Example 4 | 12 | EP6050G (100) | PE2 (40) | PAG2 (2.0) | ' | BTA (0.10) | PGMEA (20) CP (80) | |

Each of resist solutions 1 to 12 was coated onto a thermoplastic film in the form of PET film of 38 µm thick in a clean room of cleanness 1,000, humidity 40-45%, and temperature 22-26°C using a film coater in the form of die coater. The coating was dried in a hot air circulating oven at the temperature shown in Table 2 for 5 minutes, yielding a laminate having a negative resist film of 40 µm thick. A protective film in the form of PE film of 50 µm thick was bonded to the resist film surface under a pressure of 1 MPa, yielding a negative resist film laminate in roll form (laminates 1 to 12).

**[Table 2]**

| | Negative resist film laminate | Resist solution | Oven temperature (°C) |
|---|---|---|---|
| Example 1 | 1 | 1 | 100 |
| Example 2 | 2 | 2 | 95 |
| Example 3 | 3 | 3 | 100 |
| Example 4 | 4 | 4 | 100 |
| Example 5 | 5 | 5 | 105 |
| Example 6 | 6 | 6 | 90 |
| Example 7 | 7 | 7 | 110 |
| Example 8 | 8 | 8 | 100 |
| Comparative Example 1 | 9 | 9 | 100 |
| Comparative Example 2 | 10 | 10 | 110 |
| Comparative Example 3 | 11 | 11 | 105 |
| Comparative Example 4 | 12 | 12 | 95 |

### [3] Evaluation of void occurrence

First, the protective film was peeled from each of the negative resist film laminates 1 to 12 prepared above. Using a vacuum laminator TEAM-100M (Takatori Co., Ltd.) whose vacuum chamber was set at a vacuum of 80 Pa, the negative resist film on the thermoplastic film was transferred to a Cu substrate of diameter 200 mm having steps of 50 µm at the maximum. The temperature was 60°C. With the chamber restored to atmospheric pressure, the substrate was taken out of the laminator, and the thermoplastic film was peeled off. The resist film-bearing substrate was observed under an optical microscope (by Nikon Corp.) to inspect any voids on the substrate. For each of Examples and Comparative Examples, the test was performed 5 times, and an average was calculated and used for judgment. A void-free film was judged good (Q). The results are shown in Table 3.

**[Table 3]**

| | Negative resist film laminate | Void occurrence |
|---|---|---|
| Example 1 | 1 | ○ |
| Example 2 | 2 | ○ |
| Example 3 | 3 | ○ |
| Example 4 | 4 | ○ |
| Example 5 | 5 | ○ |
| Example 6 | 6 | ○ |
| Example 7 | 7 | ○ |
| Example 8 | 8 | ○ |
| Comparative Example 1 | 9 | ○ |
| Comparative Example 2 | 10 | Cracked during lamination |
| Comparative Example 3 | 11 | Cracked during lamination |
| Comparative Example 4 | 12 | ○ |

### [4] Evaluation of storage stability

The above-prepared negative resist film laminates 1 to 12 in roll form were stored at 23°C for 1 month, after which the film state was observed. The results are shown in Table 4.

**[Table 4]**

| | Negative resist film laminate | Storage stability |
|---|---|---|
| Example 1 | 1 | unchanged |
| Example 2 | 2 | unchanged |
| Example 3 | 3 | unchanged |
| Example 4 | 4 | unchanged |
| Example 5 | 5 | unchanged |
| Example 6 | 6 | unchanged |
| Example 7 | 7 | unchanged |
| Example 8 | 8 | unchanged |
| Comparative Example 1 | 9 | unchanged |
| Comparative Example 2 | 10 | Cracked during service |
| Comparative Example 3 | 11 | Cracked during service |
| Comparative Example 4 | 12 | unchanged |

### [5] Evaluation of pattern formation

Using a vacuum laminator, each of the negative resist film laminates 1 to 12 was laminated onto a 8-inch silicon wafer having Cu deposited thereon by sputtering. This was followed by prebake on a hotplate at 110°C for 5 minutes. Using an i-line stepper (NSR-2205i11D by Nikon Corp.), the photosensitive resin coating was exposed to radiation through a reticle, baked (PEB) at 100°C for 2 minutes, spray developed in an alkaline developer in the form of 2.38 wt% TMAH aqueous solution for 5 minutes, and dried, yielding a pattern.

The resulting pattern was observed under a scanning electron microscope (S-4700 by Hitachi High-Technologies Corp.), from which the optimum dose and resolution were determined. The optimum dose is a dose at which holes of 50 µm were printed from a hole pattern of size 50 µm. The resolution is a mask size at which the smallest hole pattern is resolved in the optimum dose. The results are shown in Table 5.

**[Table 5]**

| | Negative resist film laminate | Optimum dose (mJ/cm²) | Resolution (µm) |
|---|---|---|---|
| Example 1 | 1 | 150 | 10 |
| Example 2 | 2 | 200 | 10 |
| Example 3 | 3 | 600 | 8 |
| Example 4 | 4 | 800 | 5 |
| Example 5 | 5 | 550 | 8 |
| Example 6 | 6 | 900 | 8 |
| Example 7 | 7 | 150 | 10 |
| Example 8 | 8 | 100 | 10 |
| Comparative Example 1 | 9 | 300 | 10 |
| Comparative Example 2 | 10 | Pattern not formed | - |
| Comparative Example 3 | 11 | 750 | 8 |
| Comparative Example 4 | 12 | Pattern not formed | - |

### [6] Evaluation of solvent resistance

Using a vacuum laminator, each of the negative resist film laminates 1 to 12 was laminated onto a 8-inch silicon wafer. The wafer was prebaked on a hotplate at 110°C for 5 minutes and heat treated in an oven at 190°C for 2 hours. Thereafter, the wafer was immersed in each of the solvents in Table 6 at 50°C for 15 minutes. The sample which remained undissolved is rated good (○), the sample which was partially dissolved is rated mediocre (△), and the sample which was completely dissolved is rated poor (×).

**[Table 6]**

| | Negative resist film laminate | N-methylpyrrolidone | 2-aminoethanol | Dimethyl sulfoxide | Ethylene carbonate |
|---|---|---|---|---|---|
| Example 1 | 1 | ○ | ○ | ○ | ○ |
| Example 2 | 2 | ○ | ○ | ○ | ○ |
| Example 3 | 3 | ○ | ○ | ○ | ○ |
| Example 4 | 4 | ○ | ○ | ○ | ○ |
| Example 5 | 5 | ○ | ○ | ○ | ○ |
| Example 6 | 6 | ○ | ○ | ○ | ○ |
| Example 7 | 7 | ○ | ○ | ○ | ○ |
| Example 8 | 8 | ○ | ○ | ○ | ○ |
| Comparative Example 1 | 9 | ○ | Δ | ○ | Δ |
| Comparative Example 2 | 10 | × | × | × | × |
| Comparative Example 3 | 11 | ○ | × | ○ | × |
| Comparative Example 4 | 12 | × | × | × | × |

## Claims

1. A negative resist film laminate comprising a thermoplastic film as a first support and a negative resist film, the negative resist film comprising
(A) an alkali-soluble resin having a phenolic hydroxy group,
(B) a plasticizer containing a polyester,
(C) a photoacid generator,
(D) an epoxy compound containing on average at least 4 epoxy groups per molecule, and
(E) a benzotriazole compound and/or imidazole compound.

2. The laminate of claim 1 wherein the polyester is a polyfunctional carboxylic acid polyester having 2 to 6 carboxy groups.

3. A method for forming a pattern, comprising the steps of:
(1) transferring the negative resist film of the laminate of claim 1 or 2 to a second support,
(2) exposing the resist film to radiation, and
(3) developing the resist film in an alkaline aqueous solution.

4. The pattern forming method of claim 3 wherein step (1) includes heat treatment after the transfer.

5. The pattern forming method of claim 3 or 4 wherein step (2) includes heat treatment after the exposure.
